# EUROPEAN PATENT APPLICATION

(11) **EP 3 170 878 A1**
(43) Date of publication of application: **24.05.2017**
(21) Application number: 15822046.7
(22) Date of filing: 17.07.2015
(51) Int. Cl.: C09J 175/06, C09J 11/06, C09J 133/14, C09J 167/00, C09J 175/04, C09J 201/06, H01L 31/049

(54) **ADHESIVE FOR SOLAR-CELL BACKSHEET, POLYOL COMPOSITION FOR SOLAR-CELL BACKSHEET ADHESIVE, SOLAR-CELL BACKSHEET, AND SOLAR CELL MODULE**

(30) Priority: 18.07.2014 JP 2014147723
(71) Applicant: DIC Corporation, Tokyo 174-8520 (JP)
(72) Inventor: UMINO Akio, Ichihara-shi Chiba 290-8585 (JP); AKITA Kouji, Tokyo 174-8520 (JP); UNO Seiichi, Ichihara-shi Chiba 290-8585 (JP); YAMASHITA Kousei, Tokyo 174-8520 (JP); MIKI Shou, Tokyo 174-8520 (JP)
(74) Representative: TBK
(86) International application number: PCT/JP2015/070482
(87) International publication number: WO 2016/010132

(57) **Abstract**

There are provided an adhesive for a solar-cell back sheet having an excellent curing rate and being capable of exhibiting excellent adhesive performance by short-term aging, and also a polyol composition used for the adhesive, a solar-cell back sheet using the adhesive, and a solar-cell module using the sheet. The adhesive for a solar-cell back sheet contains, as essential components, at least one hydroxyl group-containing resin (A) selected from a polyester polyurethane polyol (A1), a polyester polyol (A2), a hydroxyl group-containing (meth)acrylic resin (A3), and a hydroxyl group-containing fluorocarbon resin (A4), a polyisocyanate (B), and a cyclic amide compound (C).

## Description

### Technical Field

The present invention relates to an adhesive containing, as essential components, at least one hydroxyl group-containing resin (A) selected from a polyester polyurethane polyol (A1), a polyester polyol (A2), a hydroxyl group-containing (meth)acrylic resin (A3), and a fluorocarbon resin (A4), polyisocyanate (B), and a cyclic amide compound (C), and also relates to a polyol composition used for the adhesive, a solar-cell back sheet using the adhesive, and a solar-cell module.

### Background Art

In recent years, fossil fuels such as coal and petroleum have been under threat of depletion, and there has been urgent need for development to secure energy alternative to the fossil fuels. Therefore, various methods such as nuclear power generation, hydroelectric generation, wind power generation, photovoltaic power generation, etc. have been researched and have reached practical use. Photovoltaic power generation capable of directly converting solar energy to electric energy is being brought into practical use as a new semi-permanent and pollution-free energy source, and the cost-performance ratio in practical use is remarkably improved, resulting in the high expectation as a clean energy source.

A solar cell used for photovoltaic power generation constitutes the heart of a photovoltaic power generation system, which directly converts solar energy to electric energy, and is composed of a semiconductor exemplified by silicon. The structure thereof includes solar-cell elements which are arranged series and in parallel and are packaged to form a unit in various manners for protecting the elements over a time as long as about 30 years. The unit assembled into the package is referred to as a "solar-cell module" generally having a glass-coated surface, which receives sunlight, and a back surface protected by a protective sheet (back sheet) with the gap filled with a sealing material composed of a thermoplastic resin.

An ethylene-vinyl acetate copolymer resin (abbreviated as an "EVA resin" hereinafter) is mainly used as the thermoplastic resin as the sealing material for the reason of high transparency and excellent moisture resistance. On the other hand, the back protective sheet (back sheet) is required to have characteristics such as mechanical strength, weather resistance, heat resistance, moist heat resistance, and light resistance, and thus widely used is a sheet including a PET film as a substrate film on which a white fluorine film containing an inorganic pigment is laminated for the purpose of imparting light resistance.

An adhesive used for laminating the PET film and the substrate film is required to have adhesive strength with long-term reliability because the back sheet is exposed to an outdoor environment over many years, and from this viewpoint, a polyisocyanate-curable adhesive is widely used. A known example of the polyisocyanate-curable adhesive for a back sheet is an adhesive which has been known as an adhesive capable of exhibiting a high level of adhesive performance even in a severe environment under moist heat conditions, and the adhesive contains polyisocyanate as a curing agent and a polyester polyurethane polyol as a main agent which has a branched structure introduced in its molecular structure, a weight-average molecular weight (Mw) within a range of 25,000 to 200,000, and a wide molecular weight distribution [(Mw/Mn) is within a range of 2.5 to 25] (refer to Patent Literature 1 below).

However, the adhesive described in Patent Literature 1 exhibits excellent adhesive performance even in a moist heat environment, but aging for several days is required for sufficient curing because of its low curing rate. Specifically, an aging step at 40°C for about 3 to 5 days is currently required, and this causes a decrease in productivity of the back sheet.

### Citation List

### Patent Literature

PTL 1: Japanese Patent No. 5170349

### Summary of Invention

### Technical Problem

A problem to be solved by the present invention is to provide an adhesive for a solar-cell back sheet having an excellent curing rate and being capable of exhibiting excellent adhesive performance by short-term aging, and also provide a polyol composition used for the adhesive, a solar-cell back sheet using the adhesive, and a solar-cell module using the sheet.

### Solution to Problem

As a result of earnest research for solving the problem the present inventors found that a curing rate is remarkably improved by mixing a cyclic amide compound in addition to a polyol component serving as a main agent and a polyisocyanate component serving as a curing agent, and thus excellent adhesive strength is exhibited by short-term aging, leading to the achievement of the present invention.

That is, the present invention relates to an adhesive for a solar-cell back sheet, the adhesive containing as essential components at least one hydroxyl group-containing resin (A) selected from a polyester polyurethane polyol (A1), a polyester polyol (A2), a hydroxyl group-containing (meth)acrylic resin (A3), and a hydroxyl group-containing fluorocarbon resin (A4), a polyisocyanate (B), and a cyclic amide compound (C).

Also, the present invention relates to a polyol composition for a solar-cell back sheet adhesive containing, as essential components, at least one hydroxyl group-containing resin (A) selected from a polyester polyurethane polyol (A1), a polyester polyol (A2), a hydroxyl group-containing (meth)acrylic resin (A3), and a hydroxyl group-containing fluorocarbon resin (A4), and a cyclic amide compound (C).

Also, the present invention relates to a solar-cell back sheet including a laminate film in which a first substrate sheet, an adhesive layer, and a second substrate sheet are laminated in that order, and the adhesive layer is composed of a cured product of the adhesive for a solar-cell back sheet.

Further, the present invention relates to a solar-cell module including a solar cell, a surface protective substrate disposed on the light absorption-side surface of the solar cell, and a solar cell back sheet disposed on the back side of the solar cell, the gap between the surface protective substrate and the back sheet being sealed with a sealing material for a solar cell.

### Advantageous Effects of Invention

According to the present invention, it is possible to provide an adhesive for a solar-cell back sheet having an excellent curing rate and being capable of exhibiting excellent adhesive performance by short-term aging, and also provide a polyol composition used for the adhesive, a solar-cell back sheet using the adhesive, and a solar-cell module using the sheet.

Also, an organic tin catalyst, specifically, dibutyltin dilaurate (DBTDL), octyltin maleate, or the like, is widely used as a catalyst for urethanization reaction by polyisocyanate curing. However, the problem of toxicity of the organic tin catalyst has recently been pointed out, but the present invention can enhance curability without using such a tin-based catalyst.

### Description of Embodiments

An adhesive for a solar-cell back sheet of the present invention is a two-component mixed adhesive containing a hydroxyl group-containing resin (A) as a main agent and a polyisocyanate (B) as a curing agent, wherein a cyclic amide compound (C) is used in addition to these components.

The hydroxyl group-containing resin (A) used is one or more selected from polyester polyurethane polyol (A1), polyester polyol (A2), a hydroxyl group-containing (meth)acrylic resin (A3), and a fluorocarbon resin (A4). One of the resins may be used or a plurality of resins may be used.

An example of the polyester polyurethane polyol (A1) is a resin produced by reacting a polyol (a1), a polycarboxylic acid (a2), and a polyisocyanate (b1).

Examples of the polyol (a1) include aliphatic diols such as ethylene glycol, propylene glycol, 1,3-propanediol, 1,4-butanediol, 1,5-pentanediol, 1,6-hexanediol, diethylene glycol, triethylene glycol, tetraethylene glycol, dipropylene glycol, tripropylene glycol, dimer diol, and the like; aliphtatic diols each having a branched structure in its molecular structure, such as 3-methyl-1,5-pentanediol, 2,2,4-trimethyl-1,3-pentanediol, neopentylglycol, methylpentanediol, dimethylbutanediol, 1,2,2-trimethyl-1,3-propanediol, 2,2-dimethyl-3-isopropyl-1,3-propanediol, 3-methyl-1,3-butanediol, 1,4-cyclohexanediol, 1,4-cyclhexanedimethanol, hydrogenated bisphenol A, and the like; aromatic diols such as bishydroxyethoxybenzene, bisphenol A, and the like; polyester polyols produced by ring-opening polymerization reaction of cyclic ester compounds such as propiolactone, butyrolactone, ε-caprolactone, δ-valerolactone, β-methyl-δ-valerolactone, and the like; polyetherdiols produced by addition polymerization of monomers such as ethylene oxide, propylene oxide, butylene oxide, styrene oxide, epichlorohydrin, tetrahydrofuran, cyclohexylene, and the like using as an initiator a compound having two active hydrogen atoms, such as ethylene glycol, diethylene glycol, triethylene glycol, propylene glycol, trimethylene glycol, 1,3-butanediol, 1,4-butanediol, 1,6-hexanediol, neopentylglycol, or the like; tri- or higher-functional aliphatic polyols such as trimethylolethane, trimethylolpropane, glycerin, hexanetriol, pentaerythritol, and the like;
tri- or higher-functional modified polyether polyols produced by ring-opening polymerization of the tri- or higher-functional aliphatic polyols described above with various cyclic ester bond-containing compounds such as ethylene oxide, propylene oxide, tetrahydrofuran, ethyl glycidyl ether, propyl glycidyl ether, butyl glycidyl ether, phenyl glycidyl ether, allyl glycidyl ether, and the like; and
tri- or hither-functional polyols such as lactone-based polyester polyols produced by polycondensation reaction of the tri- or higher-functional aliphatic polyols with various lactones such as ε-caprolactone and the like.

Examples of the polycarboxylic acid (a2) include aliphatic dicarboxylic acids such as succinic acid, adipic acid, suberic acid, azelaic acid, sebacic acid, undecanedioic acid, dodecane dicarboxylic acid, tridecanedioic acid, fumaric acid, 1,3-cyclopentane dicarboxylic acid, 1,4-cyclohexane dicarboxylic acid, maleic anhydride, dimer acid, and the like;
terephthalic acid, isophthalic acid, 1,4-naphthalene dicarboxylic acid, 2,5-naphthalene dicarboxylic acid, 2,6-naphthalene dicarboxylic acid, naphthalic acid, biphenyl dicarboxylic acid, 1,2-bis(phenoxy)ethane-p,p'-dicarboxylic acid, and anhydrides or ester-forming derivatives of these dicarboxylic acids; aromatic dicarboxylic acids such as p-hydroxybenzoic acid, p-(2-hydroxyethoxy)benzoic acid, ester-forming derivatives of these dihydroxycarboxylic acids, and the like; aliphatic tribasic acids such as 1,2,5-hexane tricarboxylic acid, 1,2,4-cyclohexane tricarboxylic acid, and the like;
aromatic tribasic acids such as trimellitic acid, trimellitic anhydride, 1,2,5-benzene tricarboxylic acid, 2,5,7-naphthalene tricarboxylic acid, and the like, and anhydrides thereof.

Examples of the polyisocyanate (b1) include organic compounds each having at least two isocyanate groups in its molecule, for example, aromatic diisocyanates such as tolylene diisocyanate, diphenylmethane diisocyanate, 1,5-naphthalene diisocyanate, and the like; aliphatic diisocyanates such as 1,6-hexamethylene diisocyanate, xylylene diisocyanate, isophorone diisocyanate, 4,4'-methylene bis(cyclohexylisocyanate), lysine diisocyanate, trimethylhexamethylene diisocyanate, 1,3-(isocyanatomethyl)cyclohexane, and the like; and tri- or higher-functional polyisocyanates such as triphenylmethane triisocyanate, trimethylol-adducts of the aliphatic diisocyanates, trimethylol-adducts of the aromatic diisocyanates, burettes of the aliphatic diisocyanates, burettes of the aromatic diisocyanates, isocyanurates of the aliphatic diisocyanates, isocyanurates of the aromatic diisocyanates, and the like.

The polyester polyurethane polyol (A1) used in the present invention can be produced by reacting the polyol (a1), the polycarboxylic acid (a2), and the polyisocyanate (b1) according to a standard method using the examples of compounds described above in proper combination. In particular, a polyester polyurethane polyol (A'1) having a branched structured in its molecule, a weight-average molecular weight (Mw) within a range of 25,000 to 200,000, and a molecular weight distribution (Mw/Mn) of 2.5 or more is preferred from the viewpoint of shortening the aging time and producing an adhesive having good adhesion to a substrate under mist heat conditions.

When the polyester polyurethane polyol (A'1) has a weight-average molecular weight (Mw) within a range of 25,000 to 200,000, a cured product exhibits high strength, and the adhesive has excellent initial adhesive strength and a viscosity suitable for coating. In particular, the weight-average molecular weight (Mw) is within a range of 30,000 to 100,000 from the viewpoint of producing a resin composition having high initial adhesive strength and excellent adhesion to a substrate under moist heat conditions.

Also, when the polyester polyurethane polyol (A'1) has a molecular weight distribution (Mw/Mn) of 2.5 or more, the effect of improving adhesion to a substrate due to a low-molecular-weight component and the effect of increasing the strength of a cured product due to a high-molecular-weight component are simultaneously exhibited, thereby causing excellent substrate adhesion under moist heat conditions and high initial adhesive strength. In particular, the molecular weight distribution (Mw/Mn) is preferably within a range of 3 to 25, more preferably within a range of 4 to 15, and particularly preferably within a range of 6 to 10 from the viewpoint of producing a resin composition having excellent substrate adhesion under moist heat conditions.

In the present invention, the weight-average molecular weight (Mw) and number-average molecular weight (Mn) are values measured by gel permeation chromatography (GPC) under conditions described below.

Measurement apparatus: HLC-8220GPC manufactured by Tosoh Corporation
Column: TSK-GUARDCOLUMN Super HZ-L manufactured by Tosoh Corporation
+ TSK-GEL Super HZM-Mx4 manufactured by Tosoh Corporation
Detector: RI (differential refractometer)
Data processing: multi-station GPC-8020 model III manufactured by Tosoh Corporation
Measurement condition:
   Column temperature: 40°C
   Solvent: tetrahydrofuran
   Flow rate: 0.35 ml/min
Standard: monodisperse polystyrene
Sample: prepared by filtering a 0.2 mass% tetrahydrofuran solution in terms of resin solid content with a microfilter (100 µl).

Further, the hydroxyl value of the polyester polyurethane polyol (A'1) is preferably within a range of 5 to 30 mgKOH/g and more preferably within a range of 7 to 15 mgKOH/g in view of excellent substrate adhesion under moist heat conditions.

In the polyester polyurethane polyol (A'1), a branched structure can be introduced into the molecule of the finally resulting polyester polyurethane polyol (A'1) by using a tri- or higher-functional compound as any one of the polyol (a1), the polycarboxylic acid (a2), and the polyisocyanate (b1). For example, the tri- or higher-functional polyol is used as the polyol (a1), the aliphatic tribasic acid or the aromatic tribasic acid and anhydride thereof is used as the polycarboxylic acid (a2), or the tri- or higher-functional polyisocyanate is used as the polyisocyanate (b1).

As the polycarboxylic acid (a2) for producing the polyester polyurethane polyol (A'1), an aliphatic dicarboxylic acid or aliphatic tricarboxylic acid within a range of 8 to 13 carbon atoms, such as suberic acid, azelaic acid, sebacic acid, undecanedioic acid, dodecanedioic acid, tridecanedioic acid, 1,2,5-hexane tricarboxylic acid, 1,2,4-cyclohexane tricarboxylic acid, or the like, is preferably used in combination with the aromatic dicarboxylic acid or aromatic tricarboxylic acid from the viewpoint of producing the adhesive having excellent substrate adhesion under moist heat conditions and viscosity suitable for coating. Specifically, the content of aliphatic polybasic acid in the polycarboxylic acid (a2) is preferably within a range of 20 to 50 mol%.

In addition, in the present invention, for the purpose of adjusting the molecular weight and viscosity of the polyester polyurethane polyol (A'1), a monocarboxylic acid such as methanoic acid, ethanoic acid, propanoic acid, butanoic acid, pentanoic acid, hexanoic acid, heptanoic acid, octanoic acid, nonanoic acid, decanoic acid, dodecanoic acid, tetradecanoic acid, hexadecanoic acid, heptadecanoic acid, octadecanoic acid, benzoic acid, or the like may be used as a raw material for the polyester polyurethane polyol (A).

In addition, the content of the aliphatic alcohol in the polyol (a1) component is preferably 50 mol% or more and more preferably 80 mol% or more in view of excellent coatability of the adhesive.

Further, the polyisocyanate (b1) used for producing the polyester polyurethane polyol (A'1) is preferably the tri- or higher-functional polyisocyanate compound and more preferably the nurate-type polyisocyanate compound from the viewpoint of producing a resin composition having excellent adhesive strength under moist heat conditions. Also, the diisocyanate compound is preferably used in combination with the tri- or higher-functional polyisocyanate compound from the viewpoint of easily adjusting a resin composition to have viscosity suitable for coating. In this case, the mass ratio [diisocyanate compound/tri- or higher-functional polyisocyanate compound] between both is preferably within a range of 50/50 to 5/95 from the viewpoint of producing a resin composition exhibiting excellent substrate adhesion under moist heat conditions and viscosity suitable for coating.

The method for producing the polyester polyurethane polyol (A1) is, for example, a method including reacting the polyol (a1) with the polycarboxylic acid (a2) in the presence of an esterification catalyst within a temperature range of 150°C to 270°C to produce a polyester polyol, and then reacting the polyester polyol with the polyisocyanate (b1) in the presence of an urethanization catalyst within a temperature range of 50°C to 100°C.

Next, any polyester resin produced by reacting the polyol (a1) with the polycarboxylic acid (a2) can be used as the polyester polyol (A2). In particular, a polyester polyol (A'2) having a branched structure in its molecule, a weight-average molecular weight (Mw) within a range of 10,000 to 100,000, and a molecular weight distribution (Mw/Mn) within a range of 3.0 to 4.7 is preferred in view of excellent adhesive strength and moist heat resistance after curing. Specifically, when the weight-average molecular weight (Mw) is within a range of 10,000 to 100,000, proper viscosity with excellent coatability can be achieved without using a large amount of solvent, the initial adhesive strength can be improved due to an increase in amount of the resin coated, and the time of the aging step can be further shortened.

Also, when the polyester polyol has a molecular weight distribution (Mw/Mn) of 3.0 or more, adhesion to a substrate is improved when used as a two-component adhesive for a laminate, and adhesive strength and moist heat resistance after curing are improved, while with the molecular weight distribution (Mw/Mn) within a range of 4.7 or less, adhesive strength after curing is improved.

The polyester polyol having a branched structure in its molecule, a weight-average molecular weight (Mw) within a range of 10,000 to 100,000, and a molecular weight distribution (Mw/Mn) within a range of 3.0 to 4.7 is produced by, for example, a method using, as the polyol (a1), the aliphatic diol having a branched structure in its molecular structure and using, as the polycarboxylic acid (a2), an aliphatic dicarboxylic acid having 8 to 13 carbon atoms and an aromatic polybasic acid having three or more carboxylic acid groups in one molecule.

Examples of a branched alkylene diol used as the polyol (a1) include alkylene diols each having a tertiary carbon atom or quaternary carbon atom in its molecular structure, such as 3-methyl-1,5-pentanediol, 2,2,4-trimethyl-1,3-pentanediol, neopentyl glycol, methylpentanediol, dimethylbutanediol, 1,2,2-trimethyl-1,3-propanediol, 2,2-dimethyl-3-isopropyl-1,3-propanediol, 3-methyl-1,3-butanediol, 1,4-cyclohexanediol, 1,4-cyclohexanedimethanol, hydrogenated bisphenol A, and the like. Among these, neopentylglycol is particularly preferred in view of excellent moist heat resistance.

Examples of the aliphatic dicarboxylic acid having 8 to 13 carbon atoms include suberic acid, azelaic acid, sebacic acid, undecanedioic acid, dodecanedioic acid, tridecanedioic acid, 1,2,5-hexane tricarboxylic acid, 1,2,4-cyclohexane tricarboxylic acid, and the like. The aliphatic dicarboxylic acid having 8 to 13 carbon atoms is particularly preferred in view the point that the viscosity of the resultant polyester poly can be decreased, the adhesion to a substrate can be improved, and the appearance of a sheet after lamination can be improved. As the polycarboxylic acid (a2) for producing the polyester polyol (A2), the aliphatic dicarboxylic acid having 8 to 13 carbon atoms is preferably used in combination with the aromatic dicarboxylic acid or aromatic tricarboxylic acid from the viewpoint of producing the adhesive having excellent substrate adhesion under moist heat conditions and viscosity suitable for coating. Specifically, the aliphatic polybasic acid in the polycarboxylic acid (a2) is preferably within a range of 20 to 50 mol%.

In addition, in the present invention, for the purpose of adjusting the molecular weight and viscosity of the polyester polyol (A'2), a monocarboxylic acid such as methanoic acid, ethanoic acid, propanoic acid, butanoic acid, pentanoic acid, hexanoic acid, heptanoic acid, octanoic acid, nonanoic acid, decanoic acid, dodecanoic acid, tetradecanoic acid, hexadecanoic acid, heptadecanoic acid, octadecanoic acid, benzoic acid, or the like may be used as a raw material for the polyester polyol (A'2).

The method for producing the polyester polyol (A2) is, for example, a method of reacting the polyol (a1) with the polycarboxylic acid (a2) in the presence of an esterification catalyst within a temperature range of 150°C to 270°C to produce a polyester polyol. Examples of the esterification catalyst used include an organic tin compound, an inorganic tin compound, an organic titanium compound, an organic zinc compound, and the like.

Next, the hydroxyl group-containing (meth)acrylic resin (A3) used in the present invention is one produced by, for example, copolymerizing a hydroxyl group-containing acryl monomer, such as 2-hydroxyethyl acrylate or 2-hydroxyethyl methacrylate, with a (meth)acrylic acid alkyl ester, such as methyl (meth)acrylate, ethyl (meth)acrylate, 2-propyl (meth)acrylate, n-propyl (meth)acrylate, butyl (meth)acrylate, 2-ethylhexyl (meth)acrylate, or the like. Also, styrene can be copolymerized together with these monomers in order to decrease the moisture absorption of the resultant resin.

Next, the hydroxyl group-containing fluorocarbon resin (A4) is, example, a resin produced by copolymerizing a hydroxyl group-containing acryl monomer, such as 2-hydroxyethyl acrylate, 2-hydroxyethyl methacrylate, or the like, with at least one fluorine-containing ethylenic monomer selected from the group consisting of vinyl fluoride [VF], tetrafluoroethylene [TFE], vinylidene fluoride [VdF], chlorotrifluoroethylene [CTFE], hexafluoropropylene [HFP], hexafluoroisobutene, monomers represented by CH₂=CZ¹(CF₂)ₙZ² (wherein Z¹ is H or F, Z² is H, F, or Cl, and n is an integer of 1 to 10), perfluoro(alkylvinyl ether) [PAVE] represented by CF₂=CF-ORf¹ (wherein Rf¹ represents a perfluoroalkyl group having 1 to 8 carbon atoms), and alkyl perfluorovinyl ether derivatives represented by CF₂=CF-O-CH₂-Rf² (wherein Rf² represents a perfluoroalkyl group having 1 to 5 carbon atoms). Also, (meth)acrylic acid acryl ester or monochloroethylene may be copolymerized with the monomers. The fluorocarbon resins have excellent weather resistance, heat resistance, water vapor permeation resistance, transparency, etc., and thus prevent a raw material from deteriorating by sunlight or the like and have excellent light transmission.

Among the hydroxyl group-containing resins (A) detailed above, the polyester polyurethane polyol (A1) and the polyester polyol (A2) are particularly preferred in view of the good initial adhesive strength. In particular, the polyester polyol (A'2) having a branched structure in its molecule, a weight-average molecular weight (Mw) within a range of 10,000 to 100,000, and a molecular weight distribution (Mw/Mn) within a range of 3.0 to 4.7 is preferred in view of the excellent initial adhesive strength and excellent adhesive strength after moist heat.

Next, the polyisocyanate (B) used in the present invention functions as a curing agent in the adhesive for a solar-cell back sheet of the present invention, and the polyisocyanate (b1) used as a raw material of the polyester polyurethane polyol (A1) and the polyester polyol (A2) can be used. Examples thereof include aromatic diisocyanates such as tolylene diisocyanate, diphenylmethane diisocyanate, 1,5-naphthalene diisocyanate, and the like; aliphatic diisocyanates such as 1,6-hexamethylene diisocyanate, xylylene diisocyanate, isophorone diisocyanate, 4,4'-methylene bis(cyclohexylisocyanate), lysine diisocyanate, trimethylhexamethylene diisocyanate, 1,3-(isocyanatomethyl)cyclohexane, and the like; and tri- or higher-functional polyisocyanates such as triphenylmethane triisocyanate, trimethylol-adducts of the aliphatic diisocyanates, trimethylol-adducts of the aromatic diisocyanates, burettes of the aliphatic diisocyanates, burettes of the aromatic diisocyanates, isocyanurates of the aliphatic diisocyanates, isocyanurates of the aromatic diisocyanates, and the like. In the present invention, among these, tri- or higher-functional polyisocyanate compounds are preferred in view of the excellent initial adhesive strength and retention of strength after moist heat. In particular, when an isocyanurate of the aliphatic diisocyanate is used as the tri- or higher-functional polyisocyanate compound, good moist heat resistance after curing is exhibited, but because of the low curability of the compound, the effect of shortening the aging time by using the cyclic amide compound (C) in the present invention is significantly exhibited, resulting in causing high levels of both curability and moist heat resistance.

The equivalent ratio [NCO/OH] of isocyanate groups of the polyisocyanate (B) to hydroxyl groups of the polyol resin (A) is preferably 0.5 to 6.0, but when an epoxy resin (D) and polycarbonate diol (E) described below are used, because of the presence of hydroxyl groups derived them, the equivalent ratio [NCO/OH] of isocyanate groups of the polyisocyanate (B) to all hydroxyl groups derived from the resin of the adhesive is preferably within a range of 0.9 to 3.5 in view of excellent adhesive strength and moist heat resistance after curing.

Next, examples of the cyclic amide compound (C) used in the present invention include δ-valerolactam, ε-caprolactam, ω-enantholactam, η-capryl lactam, β-propiolactam, and the like. In the present invention, using the cyclic amide compound (C) can increase the effect rate of the adhesive and promote the shortening of the time of the aging step. Specifically, when a back sheet is produced by using a polyisocyanate-curable urethane-based adhesive, the aging step under a temperature condition of 40°C to 50°C for about 3 to 5 days is generally required, while in the present invention, a satisfactory level of adhesive strength can be exhibited by aging at 40°C for 1 day. Among the compounds described above, ε-caprolactam is preferred.

The amount of the cyclic amide compound (C) is preferably 0.05 to 8 parts by mass relative to 100 parts by mass of the hydroxyl group-containing resin (A) in view of the point that the effect of improving the initial adhesive strength and adhesive strength after moist heat is significantly exhibited.

The adhesive of the present invention preferably further uses the epoxy resin (D) in addition to the components described above in view of the improved water resistance of the adhesive and good adhesive strength after moist heat. The epoxy resin (D) is preferably a liquid or solid epoxy resin having an epoxy equivalent of 170 to 700 g/eq., and the solid epoxy resin having a softening point of 50°C to 90°C is preferred in view of easy handling, easy adjustment of the adhesive, and good adhesive strength due to the hydroxyl groups properly contained in the epoxy resin structure. The mixing ratio of the epoxy resin (D) is preferably within a range of 1 to 20 parts by mass relative to 100 parts by mass (solid content) of the polyol resin (A).

Examples of the epoxy resin (D) include bisphenol-type epoxy resins such as bisphenol A epoxy resins, bisphenol F epoxy resins, and the like; biphenyl-type epoxy resins such as biphenyl-type epoxy resins, tetramethylbiphenol-type epoxy resins, and the like; dicyclopentadiene-phenol addition reaction-type epoxy resins, and the like. These may be used alone or in combination of two or more. Among these, the bisphenol-type epoxy resins are preferred in view of the point that a resin composition having excellent substrate adhesion under moist heat conditions and excellent initial adhesive strength is produced.

The adhesive of the present invention preferably further uses the polycarbonatediol (E) in addition to the components described above in view of the improved water resistance of the adhesive and good retention of adhesive strength after moist heat. The polycarbonatediol (E) preferably has a number-average molecular weight (Mn) within a range of 500 to 3,000 from the viewpoint of appropriately increasing the hydroxyl group concentration and significantly improving the crosslink density during curing, and the number-average molecular weight (Mn) is more preferably within a range of 800 to 2,000.

The hydroxyl value of the hydroxyl group-containing aliphatic polycarbonate (E) is preferably within a range of 20 to 300 mgKOH/g and particularly preferably within a range of 40 to 250 mgKOH/g in view of excellent curable of a resin composition. In view of excellent substrate adhesion under moist heat conditions, the polycarbonatediol is preferred.

The hydroxyl group-containing polycarbonate (E) can be produced by, for example, a method of polycondensation of a polyhydric alcohol with a carbonylation agent.

For example, any one of the above-described examples of compounds used as the polyol (a1) as a raw material of the polyol can be used as the polyhydric alcohol used for producing the hydroxyl group-containing polycarbonate (E).

Examples of the carbonylation agent used for producing the hydroxyl group-containing polycarbonate (E) include ethylene carbonate, propylene carbonate, dimethyl carbonate, diethyl carbonate, dibutyl carbonate, diphenyl carbonate, and the like. These may be used alone or in combination of two or more. The mixing ratio of the hydroxyl group-containing polycarbonate (E) is preferably within a range of 1 to 20 parts by mass relative to 100 parts by mass (solid content) of the polyol resin (A).

As described above, the adhesive of the present invention is a two-component mixed adhesive containing the hydroxyl group-containing resin (A) as the main agent and the polyisocyanate (B) as the curing agent, wherein the cyclic amide compound (C) is used in addition to these components, and the cyclic amide compound (C) may be mixed with the main agent and the curing agent during use of the adhesive. However, in view of good storage stability of each of the main agent component and the curing agent component in addition to excellent workability during use, it is preferred to previously mix with the hydroxyl group-containing resin (A) used as a polyol component to prepare a polyol composition (X) and mix with the polyisocyanate (B) used as the curing agent component during use.

Specifically, in the present invention, it is preferred to prepare the polyol composition (X) for a solar-cell back sheet adhesive, which contains, as essential components, at least one hydroxyl group-containing resin (A) selected from the polyester polyurethane polyol (A1), the polyester polyol (A2), the hydroxyl group-containing (meth)acrylic resin (A3), and the hydroxyl group-containing fluorocarbon resin (A4), and the cyclic amide compound (C). In this case, as described above, the amount of the cyclic amide compound (C) used is preferably 0.05 to 8 parts by mass relative to 100 parts by mass of the hydroxyl group-containing resin (A).

Also, the polyol composition (X) preferably further contains the epoxy resin (D) and/or the polycarbonatediol (E) in addition to the hydroxyl group-containing resin (A) and the cyclic amide compound (C), and as described above, the mixing amount thereof is preferably within a range of 1 to 20 parts by mass relative to 100 parts by mass (solid content) of the hydroxyl group-containing resin (A).

If required, the adhesive for a solar-cell back sheet of the present invention detailed above may simultaneously use a pigment. Examples of the pigment which can be used include, but are not particularly limited to, organic pigments and inorganic pigments described in "Handbook of Paint Raw Materials" 1970 (edited by Japan Paint Manufacturers Association), such as an extender pigment, a white pigment, a black pigment, a gray pigment, a red pigment, a brown pigment, a green pigment, a blue pigment, a metal powder pigment, a luminous pigment, a pearl-color pigment, and the like, and plastic pigments. Specific examples of these coloring agents include various ones, and examples of organic pigments include various insoluble azo pigments such as benzidine yellow, Hansa Yellow, lake red 4R, and the like; soluble azo pigments such as lake red C, carmine 6B, Bordeaux 10, and the like;
various (copper) phthalocyanine pigments such as phthalocyanine blue, phthalocyanine green, and the like; chlorine dyeing lakes such as rhodamine lake, methyl violet lake, and the like; various mordant dye pigments such as quinoline lake, fast sky blue, and the like; various vat dye pigments such as anthraquinone pigments, thioindigo pigments, perinone pigments, and the like; quinacridone pigments such as Cinquasia Red B and the like; various dioxazine pigments such as dioxazine violet and the like; various condensed azo pigments such as cromophthal and the like; aniline black; and the like.

Examples of the inorganic pigments include various chromates such as chrome yellow, zinc chromate, molybdate orange, and the like; various ferrocyanide compounds such as Prussian blue and the like; metal oxides such as titanium oxide, zinc flower, Mapico Yellow, iron oxide, Bengala, chromium oxide green, zirconium oxide, and the like; various sulfides or selenides such as cadmium yellow, cadmium red, mercury sulfide, and the like;
sulfates such as barium sulfate, lead sulfate, and the like; various silicates such as calcium silicate, ultramarine blue and the like; carbonates such as calcium carbonate, magnesium carbonate, and the like; various phosphates such as cobalt violet, manganese violet, and the like; metal powder pigments such as aluminum powder, gold powder, silver powder, copper powder, bronze powder, brass powder, and the like; flake pigments of these metals and a mica-flake pigment; metallic pigments and pearl pigments such as a mica-flake pigment coated with a metal oxide, a micaceous iron oxide pigment, and the like; graphite; carbon black; and the like.

Examples of the extender pigment include precipitated barium sulfate, whitewash, precipitated calcium carbonate, calcium bicarbonate, marble, alumina hydrate, silica, hydrous fine powder silica (white carbon), hydrous ultrafine powder silica (Aerosil), silica sand (silica sand), talc, precipitated magnesium carbonate, bentonite, clay, kaolin, loess, and the like.

Further, examples of the plastic pigments include Grandoll PP-1000 and PP-2000S manufactured by DIC Corporation and the like.

From the viewpoint of excellent durability, weather resistance, and design, the pigment used in the present invention is more preferably titanium oxide as a white pigment, an inorganic oxide such as zinc flower or the like, or carbon black as a black pigment.

The mass ratio of the pigment used in the present invention is preferably 1 to 400 parts by mass, particularly 10 to 300 parts by mass, relative to 100 parts by mass of the adhesive component in view of excellent adhesion and antiblocking property.

If required, the adhesive of the present invention may contain additives other than the above components. Additives which are generally used for adhesives used for forming films, coating films and the like can be used as the additives. Examples of the additives include a leveling agent, inorganic fine particles such as colloidal silica, alumina sol, and the like; polymethyl methacrylate-based organic fine particles; a defoaming agent; an anti-sagging agent; a wetting dispersant; a silane coupling agent; a viscosity modifier; an ultraviolet absorber; a metal deactivator; a peroxide decomposer; a flame retardant; a reinforcing agent; a plasticizer; a lubricant; a rustproofing agent; a fluorescent whitener; an inorganic heatray absorber; a fire-proofing agent; an antistatic agent; a dehydrating agent; and the like.

The pigment and other additives described above are preferably prepared as a main agent premix mixed with the polyol composition (X) and can be prepared to be mixed with the polyisocyanate compound (B) when the adhesive is used.

By using the adhesive for a solar-cell back sheet produced as described above, a solar-cell back sheet is produced by, for example, a method of applying the adhesive of the present invention on a first substrate sheet and then laminating another second substrate sheet on the first substrate sheet after drying.

The adhesive of the present invention is applied on the first substrate sheet by a method, for example, using a coating device such as a comma coater, a roll knife coater, a die coater, a roll coater, a bar coater, a gravure roll coater, a reverse roll coater, a blade coater, a gravure coater, a micro-gravure coater, or the like. The die coater and lip coater are preferably capable of freely adjusting a coating width by a deckel attached to both ends of a die or lip part, and the amount of the two-component adhesive for a laminate applied on a plastic substrate is preferably about 1 to 50 µm in terms of dry film thickness. Also, the amount of the adhesive applied on the first substrate film is preferably within a range of 0.5 to 6.0 g/m², particularly 1.0 to 4.0 g/m².

In the laminating step, practical physical properties can be exhibited by curing the adhesive for 6 to 24 hours at room temperature or under heating after lamination.

The solar-cell back sheet produced as described above is a composite sheet with a layer configuration including the first substrate sheet, an adhesive layer made of a cured product of the adhesive of the present invention, and the second substrate sheet.

Examples of the first substrate sheet or first substrate sheet used include polyester resin sheets such as a polyethylene terephthalate sheet, a polybutylene terephthalate sheet, a polynaphthalene terephthalate sheet, and the like; polyolefin sheets such as a polyethylene sheet, a polypropylene sheet, a polycyclpentadiene sheet, and the like; fluorocarbon resin sheets such as a polyvinyl fluoride sheet, a polyvinylidene fluoride sheet, a polytetrafluoroethylene sheet, a fluorinated ethylene propylene copolymer (FEP) sheet, an ethylene-tetrafluoroethylene copolymer (ETFE) sheet, an ethylene-tetrafluoroethylene copolymer sheet, and the like, and acrylic resin sheets such as polyacrylonitrile, polymethyl methacrylate, and the like.

The first substrate sheet of the solar-cell back sheet of the present invention is preferably a polyester resin sheet, particularly a polyethylene terephthalate sheet, from the viewpoint of film rigidity and cost, and a fluorocarbon resin sheet is preferably used as the second substrate sheet from the viewpoint that when the fluorocarbon resin sheet is used in contact with the sealing material for a solar cell, adhesion between the polyethylene terephthalate sheet and the fluorocarbon resin sheet is improved while maintaining adhesion between the sealing material and the second substrate sheet. Even when the fluorocarbon resin sheet is disposed as a weather resistant resin sheet on the side exposed to the outdoor air, adhesion between the polyethylene terephthalate sheet and the fluorocarbon resin sheet is improved.

As described above, the layer configuration of the solar-cell back sheet may be a layer configuration of first substrate sheet/adhesive layer/second substrate sheet. However, when a polyester resin sheet is used as the first substrate sheet, and a fluorocarbon resin sheet is used as the second substrate sheet, the layer configuration is preferably a layer configuration of fluorocarbon resin sheet/adhesive layer/polyester resin sheet/adhesive layer/fluorocarbon resin sheet in the order from the sealing material side from the viewpoint that the fluorocarbon resin sheet functions as a weather-resistant resin sheet and has excellent adhesion to an ethylene-vinyl acetate resin (EVA resin) widely used as the solar-cell sealing material. Also, a polyolefin sheet may be used as a substrate sheet in contact with the sealing material. In this case, the layer configuration is preferably "polyolefin resin sheet/adhesive layer/polyester resin sheet/adhesive layer/fluorocarbon resin sheet" in the order from the sealing material side.

The thickness of the first substrate sheet or second substrate sheet for the back sheet described above is not particularly limited but is preferably, for example, within a range of 10 to 400 µm. The adhesive of the present invention can exhibit excellent adhesion without an influence such as warpage, settling, or the like of the substrate and can impart excellent weather resistance by coating a small amount and drying at low temperature for a short time, and thus the thickness is preferably within a range of 80 to 300 µm.

A solar-cell module using the solar-cell back sheet of the present invention described above includes, for example, a solar cell, a surface protective substrate provided on the light absorption side-surface of the solar cell, and a back sheet disposed on the back side of the solar cell, the gap between the surface protective substrate and the back sheet being sealed with the sealing material for a solar cell, and the solar-cell back sheet of the present invention can be used as the back sheet.

Examples of the cell surface protective material include a glass plate, plastic plates of polycarbonate and polyacrylate, and the like. Use of the polycarbonate or polyacrylate can exhibit good adhesion when an adhesive coating agent of the present invention is applied on a surface in contact with the sealing material, but the glass plate is preferred in view of transparency, weather resistance, and toughness. Further, a white glass plate having high transparency is preferred as the glass plate.

Also, an ethylene-vinyl acetate resin (EVA) can be used as the sealing material for the solar-cell module of the present invention.

Examples of the solar cell include a single crystal silicon-based solar cell element, a polycrystalline silicon-based solar cell element, an amorphous silicon-based solar cell element of a single-junction type, a tandem structure type, or the like, a solar cell element composed of a group III-V compound semiconductor such as gallium arsenide (GaAs), indium phosphide (InP), or the like, a solar cell element composed of a group II-VI compound semiconductor such as cadmium telluride (CdTe) or the like, a solar cell element composed of a group I-III-VI compound semiconductor such as copper/indium/selenium (CIS-based), copper/indium/gallium/selenium (CIGS-based), copper/indium/gallium/selenium/sulfur (CIGSS-based), or the like, a dye sensitized solar cell element, an organic solar cell element, and the like.

A method for producing the solar-cell module is, for example, a method of disposing, on the cell surface protective material, an ethylene-vinyl acetate resin (EVA) sheet serving as the sealing material, a plurality of solar cells, an ethylene-vinyl acetate resin (EVA) sheet, and the back sheet of the present invention, and melting the two EVA sheets by heating under evacuation to seal the solar cell elements. In this case, a plurality of solar cell elements are connected in series by interconnectors.

### EXAMPLES

The contents and effects of the present invention are described in further detail below by giving examples.

In the examples, "parts" represents "parts by mass".

### (PRODUCTION EXAMPLE 1) [Synthesis of polyester polyurethane polyol (A1)] (EKF-892)

In a flask having a stirring rod, a temperature sensor, a rectification tube, 1131 parts of neopentyl glycol, 737 parts of isophthalic acid, 342 parts of phthalic anhydride, 534 parts of sebacic acid, 20 parts of trimellitic anhydride, and 1.3 parts of an organic titanium compound were charged and subjected to esterification reaction by heating at 230°C to 250°C under stirring while flowing dry nitrogen in the flask. When the acid value was 1.0 mgKOH/g or less, the reaction was terminated, and the reaction solution was cooled to 100°C and then diluted with ethyl acetate until the solid content was 80%. Next, 124 parts of an isocyanurate modified product of hexamethylene diisocyanurate (Sumijule N-3300; manufactured by Sumitomo Bayer Urethane Co.) and 25 parts of hexamethylene diisocyanate were charged and subjected to esterification reaction by heating at 70°C to 80°C under stirring while flowing dry nitrogen in the flask. When the isocyanate content was 0.3% or less, the reaction was terminated to produce a polyester polyurethane polyol having a number-average molecular weight of 5,700, a weight-average molecular weight of 35,000, a molecular weight distribution (Mw/Mn) of 6.1, and a hydroxyl value of 10 (mgKOH/g). The polyester polyurethane polyol was diluted with ethyl acetate to prepare a resin solution with a solid content of 62% as polyester polyurethane polyol (A1).

### (PRODUCTION EXAMPLE 2) [Synthesis of polyester polyol (A2)] (M-6199)

In a flask having a stirring rod, a temperature sensor, a rectification tube, 828 parts of neopentyl glycol, 588 parts of isophthalic acid, 274 parts of phthalic anhydride, 407 parts of sebacic acid, 15 parts of trimellitic anhydride, and 1.0 parts of an organic titanium compound were charged and subjected to esterification reaction by heating at 230°C to 250°C under stirring while flowing dry nitrogen in the flask. When the acid value was 1.0 mgKOH/g or less, the reaction was terminated to produce a polyester polyol having a number-average molecular weight of 6700, a weight-average molecular weight of 22000, a molecular weight distribution (Mw/Mn) of 3.3, and a hydroxyl value of 12 (mgKOH/g). The polyester polyol was diluted with ethyl acetate to prepare a resin solution with a solid content of 62% as polyester polyol (B1).

### (Preparation of adhesive)

An adhesive main agent was prepared by using ε-caprolactam (manufactured by Ube Industries, Ltd.) as the cyclic amide compound (C), JER1001 (epoxy equivalent 450 to 500 g/eq., softening point 64°C, molecular weight 900, manufactured by Mitsubishi Corporation) as the epoxy resin (D), and Placcel CD210 (manufactured by Daicel Corporation) having a number-average molecular weight of about 1000, a hydroxyl value of about 110 as the polycarbonate resin (E) according to Table 1.

Nurate-type hexamethylene diisocyanate Sumijule N-3300 (manufactured by Sumitomo Bayer Urethane Co.) was used as the polyisocyanate (B) for an adhesive curing agent.

The main agent containing the polyester polyurethane polyol resin, the epoxy resin, and the polycarbonate resin, and the curing agent were simultaneously mixed at each of the mixing ratios shown in Table 1 and Table 2 to prepare adhesives 1 to 7 of examples and adhesives 1 to 3 of comparative examples. In the tables, the mixing amount is a number of parts by mass in terms of solid content, and the mixing amount of the curing agent is a mixing amount relative to 100 parts by mass of the main agent.

### (Preparation of evaluation sample)

A PET film with a thickness of 125 µm (Toray Industries, Inc., X10S) was used as an original fabric, and 5 to 6 g/m² (dry mass) of each of the adhesive compositions was applied. A fluorine film (Asahi Glass Co., Ltd., Aflex 25PW) having a thickness of 25 µm was used as a film for lamination to prepare an evaluation sample. The evaluation sample was aged at 40°C for 24 hours and then subjected evaluation.

### (Preparation of evaluation sample)

A PET film with a thickness of 125 µm (Toray Industries, Inc., X10S) was used as an original fabric, and 5 to 6 g/m² (dry mass) of each of the adhesive compositions was applied. A fluorine film (Asahi Glass Co., Ltd., Aflex 25PW) having a thickness of 25 µm was used as a film for lamination to prepare an evaluation sample. The evaluation sample was aged at 40°C for 24 hours and then subjected evaluation.

### (Evaluation method)

Adhesive force: For the evaluation sample prepared through the aging step at 40°C for 24 hours, strength (N/15 mm, T-peel) at a peeling speed of 300 mm/min was evaluated as adhesive force by using a tensile tester (manufactured by SHIMADZU Corporation, AGS500NG). Also, adhesive force was measured in an initial stage (after aging) and after exposure to an environment of 121°C and 100% for each of 25 hours, 50 hours, and 75 hours.

Initial strength: The initial adhesive force was evaluated according to the following criteria:
A: 7.0 N/15 mm or more
B: 6.0 N/15 mm or more and less than 7.0 N/15 mm
C: 5.0 N/15 mm or more and less than 6.0 N/15 mm
D: Less than 5.0 N/15 mm

Moist heat resistance: The retention rate of adhesive force after 75 hours at 121°C and 100% relative to the initial adhesive force was evaluated according to the following criteria:
A: 80% or more
B: 60% or more and less than 80%
C: 40% or more and less than 60%
D: Less than 40%

[Table 1]

**Table 1**

| | | Example 1 | Example 2 | Example 3 | Example 4 | Example 5 | Example 6 | Example 7 |
|---|---|---|---|---|---|---|---|---|
| Urethane resin (A1) | | 100 | | 100 | 100 | 100 | 100 | 100 |
| Polyester resin (A2) | | | 100 | | | | | |
| Polyisocyanate (B) | | 10 | 10 | 10 | 10 | 10 | 10 | 10 |
| Cyclic amide compound (C) | | 1 | 1 | 0.1 | 5 | 1 | 1 | 1 |
| Epoxy resin (D) | | | | | | 10 | | 10 |
| Polycarbonate (E) | | | | | | | 10 | 10 |
| Equivalent ratio (NCO/OH) | | 4.67 | 4.02 | 4.67 | 4.67 | 2.41 | 1.59 | 1.26 |
| Adhesion (N/15mm) | Initial | 6.5 | 6.8 | 6.6 | 5.9 | 7.4 | 6 | 6.5 |
| | 121°C 100%:25h | 6 | 6.2 | 6 | 5.6 | 6.8 | 5.8 | 6.3 |
| | 121°C 100%:50h | 5.2 | 5.7 | 5.7 | 5.2 | 6 | 5.4 | 5.8 |
| | 121°C 100%:75h | 4.1 | 4.5 | 4.4 | 4 | 5 | 5 | 5 |
| Initial strength | | B | B | B | C | A | B | B |
| Moist heat | | B | B | B | B | B | A | B |

[Table 2]

**Table 2**

| | | Comparative Example 1 |
|---|---|---|
| Urethane resin (A1) | | 100 |
| Polyester resin (A2) | | |
| Polyisocyanate (B) | | 10 |
| Cyclic amide compound (C) | | |
| Epoxy resin (D) | | |
| Polycarbonate (E) | | |
| Equivalent ratio (NCO/OH) | | 4.67 |
| Adhesion (N/15mm) | Initial | 5.4 |
| | 121 °C100%:25h | 1.2 |
| | 121 °C100%:50h | 0.8 |
| | 121 °C100%:75h | 0.7 |
| Initial strength | | C |
| Moist heat | | D |

### Industrial Applicability

A two-component mixed adhesive composition for laminate of the present invention which contains a polyol resin (A), a polyisocyanate (B), and a cyclic amide compound (C) can be used as an adhesive for a solar-cell back sheet.

## Claims

1. An adhesive for a solar-cell back sheet, the adhesive comprising, as essential components, at least one hydroxyl group-containing resin (A) selected from a polyester polyurethane polyol (A1), a polyester polyol (A2), a hydroxyl group-containing (meth)acrylic resin (A3), and a hydroxyl group-containing fluorocarbon resin (A4), a polyisocyanate (B), and a cyclic amide compound (C).

2. The adhesive for a solar-cell back sheet according to Claim 1, further comprising an epoxy resin (D) and/or a polycarbonate diol (E).

3. The adhesive for a solar-cell back sheet according to Claim 1, wherein the adhesive is a two-component mixed adhesive including a polyol composition (X) containing the resin (A) and the cyclic amide compound (C) as essential components, and the polyisocyanate (B).

4. The adhesive for a solar-cell back sheet according to Claim 3, wherein the polyol composition (X) further contains an epoxy resin (D) and/or a polycarbonate diol (E) in addition to the hydroxyl group-containing resin (A) and the cyclic amide compound (C).

5. The adhesive for a solar-cell back sheet according to Claim 1, wherein the cyclic amide compound (C) is at least one selected from the group consisting of δ-valerolactam, ε-caprolactam, ω-eantholactam, η-capryl lactam, and β-propiolactam.

6. The adhesive for a solar-cell back sheet according to Claim 1, wherein the hydroxyl group-containing resin (A) is a polyester polyurethane resin (A1), and the polyester polyurethane resin (A1) is a polyester polyurethane polyol having a branched structured in its molecule, a weight-average molecular weight (Mw) within a range of 25,000 to 200,000, and a molecular weight distribution (Mw/Mn) of 2.5 or more.

7. The adhesive for a solar-cell back sheet according to Claim 1, wherein the hydroxyl group-containing resin (A) is a polyester resin (A2), and the polyester resin (A2) is a polyester polyol having a branched structured in its molecule, a weight-average molecular weight (Mw) within a range of 10,000 to 100,000, and a molecular weight distribution (Mw/Mn) within a range of 3.0 to 4.7.

8. The adhesive for a solar-cell back sheet according to Claim 1, wherein the polyisocyanate (B) is a tri- or higher-functional polyisocyanate compound.

9. The adhesive for a solar-cell back sheet according to Claim 1, wherein the content of the cyclic amide compound (C) is 0.05 to 10 parts by mass relative to 100 parts by mass of the hydroxyl group-containing resin (A).

10. The adhesive for a solar-cell back sheet according to Claim 2, wherein the mixing ratio of the epoxy resin (D) is 1 to 20 parts by mass relative to 100 parts by mass of the resin (A).

11. The adhesive for a solar-cell back sheet according to Claim 2, wherein the mixing ratio of the polycarbonate diol (E) is 1 to 20 parts by mass relative to 100 parts by mass of the hydroxyl group-containing resin (A).

12. A polyol composition for a solar-cell back sheet adhesive comprising, as essential components, at least one hydroxyl group-containing resin (A) selected from a polyester polyurethane polyol (A1), a polyester polyol (A2), a hydroxyl group-containing (meth)acrylic resin (A3), and a hydroxyl group-containing fluorocarbon resin (A4), and a cyclic amide compound (C).

13. The polyol composition for a solar-cell back sheet adhesive according to Claim 12, wherein the content of the cyclic amide compound (C) in the polyol mixture (X) is 0.05 to 10 parts by mass relative to 100 parts by mass of the hydroxyl group-containing resin (A).

14. A solar-cell back sheet comprising a laminate film in which a first substrate sheet, an adhesive layer, and a second substrate sheet are laminated in that order, wherein the adhesive layer includes a cured product of the adhesive for a solar-cell back sheet according to any one of Claims 1 to 11.

15. A solar-cell module comprising a solar cell, a surface protective substrate disposed on the light absorption side-surface of the solar cell, and the back sheet according to Claim 14 disposed on the back side of the solar cell, wherein the gap between the surface protective substrate and the back sheet is sealed with a sealing material for a solar cell.
